# FASCICULE DE BREVET EUROPEEN

(11) **EP 1 378 004 B1**
(45) Date de publication et mention de la délivrance du brevet: **16.01.2019**
(21) Numéro de dépôt: 02732807.9
(22) Date de dépôt: 11.04.2002
(51) Int. Cl.: H01L 21/20, H01L 21/762, H01L 21/306, H01L 21/265, H01L 21/304, H01L 21/68, H01L 21/78, B23B 31/00

(54) **PROCEDE DE REALISATION D'UN SUBSTRAT DEMONTABLE A TENUE MECANIQUE CONTROLEE**
METHODE ZUR HERSTELLUNG EINES ABMONTIERBAREN SUBSTRATES MIT KONTROLLIERBARER MECHANISCHEN FESTIGKEIT
METHOD FOR PRODUCTION OF A DETACHABLE SUBSTRATE WITH CONTROLLED MECHANICAL HOLD

(30) Priorité: 13.04.2001 FR 0105130
(43) Date de publication de la demande: 07.01.2004
(73) Titulaire: Commissariat à l'Énergie Atomique et aux Énergies Alternatives, 75015 Paris (FR)
(72) Inventeur: ASPAR, Bernard, 38140 Rives (FR); MORICEAU, Hubert, 38120 Saint-Egreve (FR); RAYSSAC, Olivier, 38000 Grenoble (FR); GHYSELEN, Bruno, 38170 Seyssinet (FR)
(74) Mandataire: Colombo, Michel
(86) Numéro de dépôt international: PCT/FR2002/001268
(87) Numéro de publication internationale: WO 2002/084722

(56) Documents cités:
- EP-A- 0 989 593
- WO-A-01/43168
- WO-A1-01/04933
- FR-A- 2 767 604
- FR-A- 2 771 852
- US-A- 6 010 591
- PATENT ABSTRACTS OF JAPAN vol. 1996, no. 05, 31 mai 1996 (1996-05-31) & JP 08 017777 A (MITSUBISHI MATERIALS SHILICON CORP;OTHERS: 01), 19 janvier 1996 (1996-01-19)
- PATENT ABSTRACTS OF JAPAN vol. 016, no. 530 (E-1287), 30 octobre 1992 (1992-10-30) & JP 04 199504 A (MITSUBISHI ELECTRIC CORP), 20 juillet 1992 (1992-07-20)
- PLOSZL A ET AL: "Wafer direct bonding: tailoring adhesion between brittle materials", MATERIALS SCIENCE AND ENGINEERING R: REPORTS, ELSEVIER SEQUOIA S.A., LAUSANNE, CH, vol. 25, no. 1-2, 10 March 1999 (1999-03-10), pages 1-88, XP004167445, ISSN: 0927-796X, DOI: 10.1016/S0927-796X(98)00017-5

## Description

### Domaine de l'invention

L'invention concerne un procédé d'assemblage de deux plaques microélectroniques. Elle trouve des applications dans la fabrication de substrats à couche mince ou dans le report de couches ou de composants sur des supports quelconques.

### Etat de la technique

De plus en plus de composants doivent être intégrés sur des supports différents de ceux permettant leur réalisation.

Par exemple, on peut citer les composants sur substrats plastiques ou sur substrats souples. Par composants, on entend tout dispositif microélectronique, optoélectronique ou capteur (par exemple chimique, mécanique, thermique, biologique ou biochimique) entièrement ou partiellement « processé », c'est à dire entièrement ou partiellement réalisé.

Pour intégrer ces composants sur des supports souples, on peut utiliser une méthode de report de couche.

Il existe de nombreux autres exemples d'applications où les techniques de report de couche peuvent fournir une solution adaptée pour l'intégration de composants ou de couches sur un support a priori différent de celui de leur réalisation. Dans le même esprit, ces techniques de transfert de couches sont également très utiles lorsque l'on souhaite isoler une couche fine, avec ou sans composant, de son substrat initial, par exemple en procédant à une séparation ou élimination de ce dernier. Encore dans le même esprit, un retournement de couche fine associé à son transfert sur un autre support fournit aux ingénieurs un degré de liberté précieux pour pouvoir concevoir des structures impossibles par ailleurs. Ces prélèvements et retournements de films minces permettent par exemple de réaliser des structures dites enterrées telles que des capacités enterrées pour les DRAMs (Dynamic Random Access Memory) où, contrairement au cas usuel, les capacités sont d'abord formées puis reportées sur un autre substrat de silicium avant de reprendre la fabrication sur ce nouveau substrat du reste des circuits. Un autre exemple concerne la réalisation de structures de transistors dites à double grille. La première grille du transistor CMOS est réalisée selon une technologie conventionnelle sur un substrat puis reportée avec retournement sur un second substrat pour reprendre la réalisation de la deuxième grille et la finition du transistor laissant ainsi la première grille enterrée dans la structure (voir par exemple K. Suzuki, T. Tanaka, Y. Tosaka, H. Horie and T Sugii, "High-Speed and Low Power n+-p+ Double-Gate SOI CMOS", IEICE Trans. Electron., vol. E78-C, 1995, pp. 360-367).

Vouloir isoler une couche mince de son substrat initial se rencontre par exemple dans le domaine des diodes électroluminescentes (LED en langage Anglo-saxon) comme il est par exemple reporté dans les documents W.S Wong et al., Journal of Electronic MATERIALS , page 1409, Vol. 28, N°12, 1999 ou I. Pollentier et al., page 1056, SPIE Vol. 1361 Physical Concepts of Materials for Novel Optoelectronic Device Applications I (1990). Un des buts recherchés ici concerne un meilleur contrôle de l'extraction de la lumière émise. Un autre but concerne le fait que dans cet exemple particulier, le substrat saphir ayant servi à réaliser l'empilement épitaxial, se retrouve à posteriori encombrant notamment du fait de son caractère électriquement isolant qui empêche tout prise de contact électrique. Pouvoir se débarrasser de ce substrat saphir dont l'emploi était avantageux pour la phase de croissance du matériau apparaît donc désormais souhaitable.

On retrouve une situation identique par exemple dans le domaine des applications liées aux télécommunications et hyperfréquence. Dans ce cas, on préfère que les composants soient intégrés en final sur un support présentant une résistivité élevée, typiquement de plusieurs kohms.cm au moins. Mais un substrat fortement résistif n'est pas forcément disponible aux mêmes coûts et qualité que les substrats standard habituellement utilisés. Dans le cas du silicium, on peut par exemple noter la disponibilité de plaques de silicium en diamètre 200 et 300mm de résistivité standard tandis que pour des résistivités supérieures à 1kohm.cm, l'offre est très inadaptée en 200mm et inexistante en 300mm. Une solution consiste à réaliser les composants sur une structure initiale comprenant un substrat standard (par exemple du silicium type p de résistivité compris entre 14 et 22 ohm.cm) puis à reporter lors des étapes finales une couche fine contenant les composants sur un substrat isolant de type verre, Quartz, saphir, etc ...

D'un point de vue technique, ces opérations de transfert ont pour intérêt majeur de décorréler les propriétés de la couche dans laquelle sont formés les composants et des propriétés du support final, et trouvent par conséquent intérêt dans bien d'autres cas encore.

On peut encore citer les cas où le substrat initial d'intérêt pour la réalisation des composants coûte excessivement cher. Dans le cas du carbure de silicium par exemple offrant de meilleures performances (températures d'utilisation plus élevées, puissances et fréquences maximum d'utilisation significativement améliorées, ...) dont le coût comparativement au silicium est très élevé, on aurait intérêt à transférer une couche fine du substrat initial cher (le carbure de silicium ici) sur le substrat final bon marché (le silicium ici), et à récupérer le résidu du substrat initial cher pour une réutilisation après éventuellement une opération de recyclage. L'opération de transfert peut avoir lieu avant, au cours ou après la réalisation des composants

Ces techniques peuvent également trouver leur intérêt dans tous les domaines où obtenir un substrat final mince est important pour l'application finale. En particulier, on peut citer les applications de puissance, que ce soit pour des raisons liées à l'évacuation de chaleur ou parce que certaines fois le courant doit traverser l'épaisseur des substrats avec des pertes en première approximation proportionnelles à l'épaisseur traversée par le courant. On peut aussi citer les applications de carte à puce pour lesquelles une finesse des substrats est recherchée pour des raisons de souplesse. Pour ces applications, la réalisation de circuits est faite sur des substrats initiaux épais ou d'épaisseur standard avec avantage d'une part de bien supporter mécaniquement les différentes étapes technologiques et d'autre part de répondre aux normes quant à leur passage sur certains équipements de production. L'amincissement est réalisé ensuite par séparation . Cette séparation peut s'accompagner d'un report sur un autre support. Dans certains cas, notamment lorsque l'épaisseur finale considérée lors de l'amincissement est suffisante pour obtenir des structures autoportées, le report sur un autre support n'est pas indispensable.

Différentes techniques peuvent être utilisées pour reporter des couches d'un support vers un autre support. Dans certains cas, l'assemblage de la couche et du support peuvent être temporaire. C'est le cas par exemple, lorsqu'on utilise pour le transfert de couches minces des substrats poignées dont le rôle est de garantir le maintien lors du transfert ou lors de différents traitements subis par la couche avant le report. On pourra se référer à ce sujet au document de T. Hamagushi et Al IEDM 1985 p 688 à 691. Une difficulté apparaît alors dans le choix des moyens mis en oeuvre pour assembler la couche et le substrat. Les moyens d'adhérence doivent notamment être suffisamment fermes pour remplir leur rôle et en particulier résister aux contraintes imposées par les traitements de la partie à transférer. Par ailleurs, l'assemblage doit pouvoir être démonté afin de libérer la couche à reporter. Des contraintes supplémentaires (thermiques, mécaniques,...) existent sur les moyens d'adhérence lorsque des composants (microélectroniques, optoélectroniques, mécaniques, piézoélectriques, supraconducteurs, ou magnétiques) doivent être réalisés en totalité ou en partie avant le transfert de la couche mince, alors que cette couche est solidaire du substrat poignée. Il faut donc que ces moyens d'adhérence soient à la fois fermes pour assurer l'assemblage entre la couche mince et le substrat poignée et ce même lors de procédés de fabrication de composants et, en même temps ces moyens d'adhérence doivent être réversibles pour assurer le détachement final du substrat-poignée.

Plus généralement, le problème posé est d'assembler une plaque avec une autre plaque, les plaques pouvant être des substrats, des couches minces ou suffisamment épaisses pour être autoportées, composites ou non, composés d'au moins un ou plusieurs matériaux semi-conducteurs, partiellement, totalement ou non processés, l'assemblage devant par la suite être démonté au niveau de l'interface d'assemblage. Avant le démontage, des composants doivent pouvoir être totalement ou partiellement réalisés sur au moins l'une des deux plaques ou une étape d'épitaxie.

Différentes solutions ont été envisagées.

La première solution consiste à éliminer la plaque support par abrasion mais dans ce cas il y a consommation de cette plaque (détruite au cours du procédé). C'est le cas également lorsqu'une couche d'arrêt à la gravure est prévue entre les deux plaques : la plaque support est consommée par une combinaison abrasion/gravure.

D'autres méthodes, basées sur le principe du " lift-off ", permettent également de séparer une couche mince préalablement collée à un support initial, sans forcément consommer ce dernier. Ces méthodes utilisent généralement des attaques chimiques attaquant sélectivement une couche intermédiaire enterré, associées ou non à des efforts mécaniques. Ce type de méthode est très utilisé pour le report d'éléments III-V sur différents types de supports (Voir : C. Camperi et al. - IEEE Transaction and photonics technology - vol 3, 12 (1991) 1123). Comme il est expliqué dans l'article de P. Demeester et al., Semicond. Sci. Tcehnol. 8 (1993) 1124-1135, le report, ayant lieu généralement après une étape d'épitaxie, peut être réalisé avant ou après la réalisation des composants ("post-processing" ou "pre-processing" respectivement selon leur dénomination Anglo-saxonne). Ces techniques basées sur le « lift-off » butent cependant sur le fait qu'il est difficile d'obtenir un décollement sur une échelle latérale supérieure au mm.

Un autre cas consiste à tirer profit de la présence d'un oxyde enterré dans le cas d'une structure SOI (Silicon On Insulator) aussi standard soit-elle (c'est à dire réalisée sans rechercher un effet démontable particulier). Si cette structure est collée de manière suffisamment forte sur un autre substrat et si on exerce une contrainte importante sur la structure, on peut obtenir une fracture non contrôlée préférentiellement dans l'oxyde, menant à une découpe à l'échelle du substrat entier. Le document « PHILIPS Journal of Research vol. 49 N°1/2 1995 » en montre un exemple en pages 53 à 55. Malheureusement, cette fracture est difficilement contrôlable et elle nécessite des contraintes mécaniques importantes pour mener à la fracture, ce qui n'est pas sans risque de casse des substrats ou de détérioration concernant les composants.

Il est connu pour reporter une couche sur un substrat final de maîtriser les énergies de liaisons comme indiqué dans le document EP0703609 A1. Mais dans ce document, il existe une première énergie de liaison entre une couche mince et un premier substrat. On contrôle alors l'énergie de liaison du contact adhérent entre la couche et le deuxième substrat, le substrat cible ou le manipulateur afin de la rendre supérieure à la première énergie de liaison, entre la couche et le premier substrat.

Les techniques utilisées pour renforcer une énergie de collage entre deux plaques sont largement connues. Elles sont utilisées dans le cas cités précédemment mais également dans d'autres cas. Il est intéressant de citer par exemple la réalisation des structures de type SOI.

Dans le cas où des structures de type SOI veulent être obtenues, les préparations de surface ont été étudiées pour fournir à terme, et souvent à l'aide d'un recuit réalisé après le collage, de fortes énergies de collage, typiquement 1 à 2 J/m². Classiquement, dans le cas d'un collage SiO₂/SiO₂ avec des préparations standard, l'énergie de collage de la structure atteint quelques dizaines de mJ/m² à température ambiante, et de 500 mJ/m² après un recuit à 400°C pendant 30 mn, (énergie de collage déterminée par la méthode de la lame développée par Maszara (Voir : Maszara et al., J Appl. Phys., 64 (10), p. 4943, 1988). Lorsque la structure est recuite à haute température (1100°C), l'énergie de collage est en général de l'ordre de 2 J/m² (C. Maleville et al., Semiconductor wafer bonding, Science Technology and Application IV, PV 97-36, 46 The Electrochemical Society Proceedings Series, Pennington, NJ (1998)). D'autres préparations avant collage existent, par exemple par exposition des surfaces à coller à un plasma (d'oxygène par exemple), et peuvent mener à des énergies équivalentes de collage sans toujours nécessiter de tels recuits (YA. Li and R.W. Bower. Jpn. J. Appl. Phys., vol 37, p. 737, 1998). Des scellements avec de telles énergies sont incompatibles avec un démontage.

Certaines variantes sont connues sous la dénomination BSOI (Bonded SOI) ou encore BESOI (Bond and Etch Back SOI). Ces variantes reposent, outre sur un collage comprenant l'adhésion moléculaire, sur un enlèvement physique du substrat initial soit par des techniques de type polissage et/ou des techniques de gravure chimique. Il y a dans ce cas, consommation du substrat.

Les inventeurs ont montré, par ailleurs, qu'en jouant sur l'hydrophilie et la rugosité des surfaces, des tenues mécaniques différentes peuvent être obtenues, supérieures ou inférieures aux tenues mécaniques classiquement obtenues. Par exemple, l'attaque HF permet, comme indiqué dans l'article de O. Rayssac et al. (Proceedings of the 2^{nd} International Conference on Materials for Microelectronics, IOM Communications, p. 183, 1998), d'augmenter la rugosité d'une couche d'oxyde de Silicium. Dans cet article, il est décrit qu'une gravure de 8000 Å augmente la rugosité d'environ 0,2 nm RMS à 0,625 nm RMS. Il a été vérifié qu'un collage SiO₂/SiO₂ avec des rugosités de 0,625 nm RMS et de 0,625 nm RMS pour les surfaces en regard, conduit à une valeur d'énergie de collage maximale de l'ordre de 500 mJ/m² après un recuit à 1000°C c'est-à-dire largement plus faible que dans le cas standard.

On connaît d'après le document FR - 2 767 604 concerne un procédé spécial de traitement pour le collage moléculaire et le décollage de deux structures. Un élément est introduit, qui est susceptible de diffuser dans la structure vers l'interface de collage ; pour le décollage, on effectue un traitement thermique qui fait diffuser l'élément vers l'interface de collage pour la fragiliser.

On connaît d'après le document US - 6 010 591 un procédé de réalisation d'une liaison démontable entre des plaquettes. Pour ce faire, avant de mettre des surfaces en contact, on dépose une ou plusieurs gouttes de liquide ; la séparation est obtenue par exposition, notamment, du liquide enfermé à l'interface à une température à laquelle ce liquide se vaporise.

On connaît d'après le document WO - 01/04933 un procédé de décollement de deux éléments selon on réalise, avant la mise en contact des surfaces, au moins une cavité pratique destinée à permettre le passage de moyens de séparation ; il est mentionné, en complément de la formation de telles cavités, la possibilité de générer des zones localisées dont l'énergie de collage est différente de celle du reste de la structure.

On connaît d'après le document FR 97 15152 un procédé decollage de deux plaques; ensuite un autre substrat est collé sur la structure et le premier collage désolidarisé.

### Problème technique et solution de l'invention

L'invention a donc pour objet une technique d'assemblage par collage par adhésion moléculaire entre deux plaques, la structure résultante étant destinée à être démontée au niveau de l'interface d'assemblage. Le démontage ou décollement de la structure est réalisé après qu'une partie ou la totalité de composants ait été réalisée sur cette couche ou encore après une étape d'épitaxie sur l'une des plaques.

Elle propose à cet effet la réalisation d'une interface par collage par adhésion moléculaire d'une face d'une plaque et d'une face d'une autre plaque avec une étape préalable de traitement appliqué à l'une au moins des faces à coller pour contrôler le niveau de tenue mécanique de l'interface. Le collage par adhésion moléculaire est réalisé avec une couche d'oxyde de silicium.

De manière préférée, dans un cas correspondant plutôt à une séparation par parties de la plaque (par puces, par composants ou ensemble et sous-ensembles de puces etc..) la préparation de cette plaque comporte une étape selon laquelle on délimite au moins une parcelle de cette couche, avant l'étape de démontage.

Pour contrôler la tenue mécanique de l'interface, une étape de préparation de l'une ou moins des deux faces à assembler est nécessaire afin d'en contrôler la rugosité et/ou l'hydrophilie.
- Pour préparer la surface en contrôlant la rugosité, on peut utiliser par exemple dans le cas de surfaces de SiO2 une attaque effectuée avec de l'acide HF. D'autres traitements chimiques sont bien sûr possibles en fonction de la nature du matériau à attaquer.
- Pour la réalisation d'un substrat démontable de type SOI, les exemples de collages SiO₂/SiO₂ et Si/SiO₂ vont être considérés. Dans un exemple qui ne fait pas partie de l'invention et dans le cas ou les natures de couches sont différentes (Si3N4 est un autre exemple classique, mais aussi les siliciures), il suffit d'utiliser des traitements chimiques adaptés (par exemple H₃PO₄ ou HF pour le Si₃N₄ par analogie avec NH₄OH/H₂O₂/H₂O (appelé aussi SC1) pour le Si).
- La tenue mécanique de l'interface est modifiée à l'aide de traitements par exemple thermiques permettant de renforcer cette interface de manière contrôlée, c'est-à-dire compatible avec un démontage ultérieur, en contrôlant les paramètres de ces traitements thermiques (le temps de traitement, la température, la montée en température...). Ces traitements thermiques comprennent ceux associés à la réalisation ultérieure de composants. Les faces ainsi traitées peuvent ensuite être collées par adhésion moléculaire, avec ou sans couche intermédiaire (telle qu'une couche d'oxyde ou de nitrure, par exemple).
- L'étape de réalisation de l'interface est suivie d'une étape de décollement des deux plaques; une étape de réalisation de tout ou partie de composants micro-électroniques, optoélectronique mécaniques, pyroélectriques, supraconducteurs ou magnétiques est effectuée avant le démontage. Entre l'étape de réalisation de l'interface et l'étape de décollement, une autre étape de collage est également effectuée pour créer une deuxième interface. Cette étape de collage comporte un collage par adhésion moléculaire. Dans ce cas, une étape de décollement, dans un exemple qui ne fait pas partie de l'invention, au niveau de cette deuxième interface peut être avantageusement réalisée par attaque acide et/ou application de contraintes mécaniques et/ou thermiques et/ou photoniques. Avantageusement, après décollement, la plaque non processée ou non reportée pourra être réutilisée,
- Les plaques sont préférentiellement en matériaux semi-conducteurs choisis préférentiellement parmi le Si, Ge, SiGe, SiC, GaN et autres nitrures équivalents, AsGa,InP ou en matériaux ferroélectriques ou piézoélectriques (LiNbO3, LiTaO3) ou magnétiques « processés » ou non.
- Une couche mince peut être réalisée dans l'une au moins des deux plaques. Cette couche mince peut être obtenue par amincissement d'un substrat initial .
- L'amincissement est obtenu par rectification et/ou polissage mécano-chimique ou non et/ou attaque chimique.
- La couche mince peut être obtenue par découpe.
- La découpe est obtenue par une fracture au niveau d'une couche fragile enterrée.
- La couche fragile enterrée est obtenue par implantation et la fractureest obtenue par traitement thermique et/ou mécanique et/ou chimique.
- L' espèce implantée est une espèce gazeuse (Hydrogène, Hélium ...).

### Brève description des dessins

Des objets, caractéristiques et avantages de l'invention ressortent de la description qui suit, donnée à titre d'exemple illustratif non limitatif en regard des dessins annexés sur lesquels :
- la figure 1 est une vue schématique en coupe de l'ensemble d'une couche mince sur un substrat, l'interface entre la couche et le substrat ayant une énergie de collage
- la figure 2 est une vue schématique de l'ensemble de la figure 1 après dépôt ou croissance d'une couche superficielle,
- la figure 3 est une vue de la structure précédente après collage moléculaire d'un deuxième substrat dit final,
- la figure 4 est une vue pendant l'application d'une action de décollement au niveau de l'interface entre la couche mince et le premier substrat,
- la figure 5 est une vue schématique d'une plaquette obtenue après décollement et un retrait de la couche d'interface rendue libre,
- la figure 6 est une vue d'un ensemble démontable du type de la figure 1,
- la figure 7 en est une vue après réalisation de composants, par exemple de la première grille de transistor,
- la figure 8 en est une vue après dépôt d'oxyde,
- la figure 9 en est une vue après planarisation (par CMP par exemple),
- la figure 10 en est une vue après collage par adhésion moléculaire (y compris traitement thermique),
- la figure 11 en est une vue après démontage et désoxydation pour retrait de la couche d'interface rendue libre,
- la figure 12 est une vue d'un ensemble démontable non revendiqué du type de la figure 1,
- la figure 13 en est une vue de l'ensemble de la figure 12 après réalisation de composants,
- la figure 14 en est une vue de l'ensemble de la figure 13 pendant le démontage par gravure HF et/ou application d'efforts mécaniques sans report sur substrat cible,
- la figure 15 en est une vue de l'ensemble de la figure 14 après démontage en un substrat final et un substrat recyclable,
- la figure 16 est une variante de la figure 13, après découpe de tranchées ou d'entailles entre les composants,
- la figure 17 en est une vue montrant un composant de l'ensemble de la figure 16 en train d'être décollé, par exemple après gravure HF,
- la figure 18 est une vue d'un ensemble, non revendiqué, analogue à la figure 1,
- la figure 19 est une vue schématique en coupe de l'ensemble de la figure 18 après collage par adhésif d'un substrat transparent,
- la figure 20 est une vue de la partie inférieure de cet ensemble de la figure 19 après décollage et polissage,
- la figure 21 est une vue de la partie supérieure de cet ensemble de la figure 19 après décollage et polissage,
- la figure 22 est une vue d'un ensemble analogue à celui de la figure 1 visualisant des zones sont éliminées par détourage mécanique et chimique,
- la figure 23 en est une vue après collage d'un substrat supérieur sur l'ensemble de la figure 22,
- la figure 24 est une vue d'un ensemble analogue à celui de la figure 1,
- la figure 25 en est une vue après dépôt d'un empilement épitaxial à base de GaN sur l'ensemble de la figure 24,
- la figure 26 en est une vue après collage d'un substrat sur l'ensemble de la figure 25,
- la figure 27 en est une vue au moment d'un décollement dans l'ensemble de la figure 26,
- la figure 28 en est une vue de la partie supérieure de l'ensemble de la figure 27 après retrait de la couche d'interface rendue libre, et
- la figure 29 en est une vue de l'ensemble de la figure 28 après enlèvement de la couche initialement sous l'empilement.

### Description de l'invention

Les exemples privilégiés qui seront retenus pour les descriptions détaillées concerneront principalement le cas du silicium, généralement disponible sous forme de substrats ronds, par exemple en diamètre de 200mm. De manière non-limitative, ces procédés se transfèrent aisément sans sortir du contexte de l'invention à d'autres systèmes caractérisés en particulier par des matériaux autres que le silicium.

Parmi les différents mode de mise en oeuvre du procédé selon l'invention, un décollement de la couche de son substrat au niveau global, c'est à dire à l'échelle de la totalité du substrat est effectué.

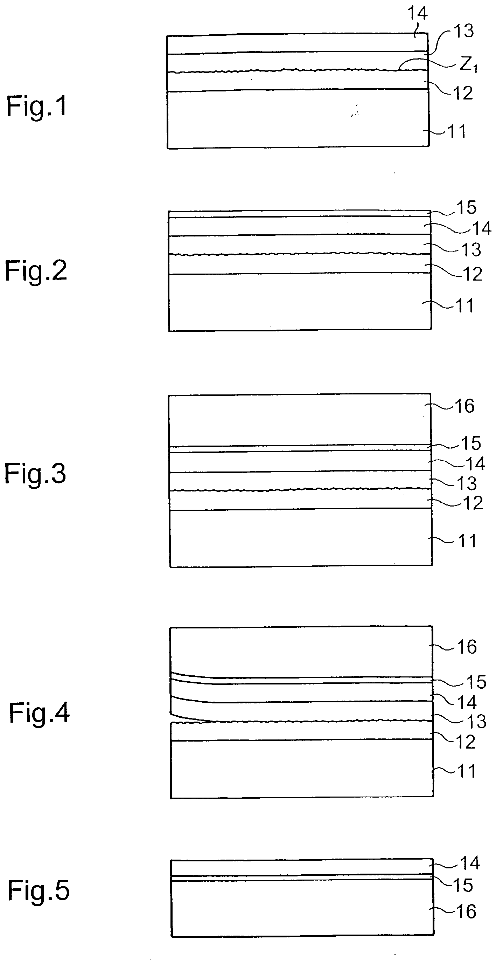

Pour la réalisation d'un substrat démontable de type SOI, les exemples de collages SiO₂/SiO₂ et Si/SiO₂ vont être considérés. Dans un exemple, qui ne fait pas partie de l'invention, et dans le cas ou les natures de couches sont différentes (Si3N4 est un autre exemple classique, mais aussi les siliciures), il suffit, par analogie avec ce qui va suivre, d'utiliser des traitements chimiques adaptés (par exemple NH₄OH/H₂O₂/H₂O (appelé aussi SC1) pour le Si et H₃PO₄ ou HF pour le Si₃N₄). La figure 1 représente l'option où le substrat (11) et la couche mince (14) sont en silicium monocristallin, et où deux couches intermédiaires (12) et (13) ont été formées préalablement au collage sur le substrat (11) et la couche mince (14) respectivement. Bien entendu, l'une seulement des deux couches intermédiaires (12) ou (13) peut suffire, ou encore aucune des deux peut n'exister (collage Si/Si). Dans le cas où ces couches intermédiaires (12) et (13) existent et sont toutes deux en SiO2, on dénomme le système par collage SiO2/SiO2. Dans le cas où l'une seule des deux existe et est en SiO₂, on dénomme le système par collage Si/SiO2.

Dans le but de réaliser une structure telle que celle décrite en figure 1, et au delà des aspects spécifiques liés au collage par adhésion moléculaire, plusieurs techniques peuvent être employées dont celles déjà citées auparavant pour la réalisation de substrats SOI non démontables (voir Semiconductor Wafer Bonding , Science and Technology, Q. Y. Tong et U. Gösele, Wiley Interscience Publication). Par la suite on appellera la couche (14) la couche active, représentant la couche qui comprendra les composants sauf pour certains cas particuliers pour lesquels une couche additionnelle épitaxiale par exemple sera déposée sur cette couche (14). Certaines variantes sont connues sous la dénomination BSOI (Bonded SOI) ou encore BESOI (Bond and Etch Back). Ces variantes reposent, outre sur un collage comprenant l'adhésion moléculaire, sur un enlèvement physique du substrat initial soit par des techniques de type polissage et/ou des techniques de gravure chimique. D'autres variantes, en partie décrites auparavant comme technique de transfert de couche, reposent en plus du collage par adhésion moléculaire sur la séparation par "découpe" le long d'une zone fragilisée telles que les méthodes décrites dans les documents US-A-5374564 (ou EP-A-533551), US-A-6020252 (ou EP-A-807970) et (séparation le long d'une zone implantée) ou encore dans le document EP 0925888 (séparation par fracture le long d'une couche enterrée porosifiée).

Concernant les aspects spécifiques liés au collage pour la réalisation de substrats démontables, dans le cas du collage SiO2/SiO2 (ou encore Si/SiO2), la couche d'oxyde peut avoir été préparée de plusieurs manières (dépôt, oxydation thermique du silicium) et présenter une épaisseur variable selon l'application. Pour cet exemple, nous pouvons choisir un oxyde thermique d'épaisseur 1 µm. On obtient ainsi la structure suivante : un substrat de silicium recouvert de 1µm d'oxyde.

On procède ensuite à une attaque HF dont le but est de rugosifier la surface de l'oxyde, rugosification dont l'importance sera croissante avec l'épaisseur d'oxyde enlevée. Pour chaque application, l'importance de cette rugosification peut être optimisée, notamment en fonction du cahier des charges du procédé de réalisation des composants (ou de croissance épitaxiale) qui devra être utilisé ultérieurement au collage sans délamination au cours du procédé de réalisation des composants et du mode retenu de mise en oeuvre du démontage final. Typiquement, un enlèvement par attaque HF d'une épaisseur d'oxyde de l'ordre de quelques dizaines à quelques centaines de nanomètres est un bon compromis de départ. Cette attaque augmente la rugosité de la couche d'oxyde (12) et/ou (13). A cela, on peut coupler un nettoyage humide ou sec sélectif pour obtenir une hydrophilie spécifique de la couche d'oxyde. On obtient ainsi un effet allant dans le sens d'un collage à tenue plus faible que le collage standard .

Une autre alternative pour maîtriser l'énergie de liaison de l'interface démontable concerne l'emploi de recuits thermiques après l'opération de collage. Une différence de température d'une centaine de degrés dans le recuit effectué après collage peut en effet, mener, surtout dans le domaine des températures au delà de 800°C à une variation significative de l'énergie de collage. Cette alternative peut-être utilisée en combinaison d'une rugosification d'une couche intermédiaire au moins (12) et/ou (13), ou seule, (c'est à dire sans étape de rugosification du tout). Un exemple très intéressant, mais qui doit en aucune manière être considéré comme limitatif, de mise en oeuvre pour un collage est de ne pas recuire l'ensemble de la structure représentée en figure 4 ou de la recuire à une température suffisamment basse, de préférence ne dépassant pas la température à laquelle seront réalisés les composants, la couche épitaxiale etc ou pour un temps court. Cette alternative reste particulièrement attrayante pour les applications ne nécessitant pas de hautes températures pour la réalisation de composants et autres structures, pour les applications ne présentant pas pour les structures de contraintes mécaniques et traitements chimiques très agressifs et pour les applications ne nécessitant pas un report sur encore un autre support après démontage (structures autoportées en final).

La rugosification et le dépôt d'oxyde ont été cités dans le cas où il sont réalisés sur le substrat (11). Une variante consiste à réaliser ces opérations du coté de la couche mince (14), voire des deux cotés.

Au delà de la réalisation du substrat dit démontable lui-même à partir de techniques basées sur le collage moléculaire, plusieurs moyens existent quant à son utilisation et aux moyens de le mettre en oeuvre.

L'intérêt de ce substrat démontable est, suivant l'épaisseur de la couche active processée (c'est à dire traitée en sorte d'y réaliser tout ou partie d'un composant) ou non, de permettre la désolidarisation de la couche active pour obtenir une couche superficielle en général plus fine reportée sur un support cible, qu'il soit le support définitif ou juste un support temporaire destiné à être lui-même démonté.

Un tel transfert de la couche superficielle sur le substrat cible peut être réalisé de différentes façons.

Tout d'abord, ce transfert peut être effectué par un nouveau collage par adhésion moléculaire de ce qui doit devenir la couche mince à transférer sur un autre substrat.

L'intérêt des substrats démontables est également de pouvoir permettre de « monter » et « démonter » à souhait des couches minces sur des substrat en permettant du fait du retournement de la couche l'élaboration totale ou partielle de composants sur les deux faces de cette couche.

A titre d'illustration, nous allons décrire un procédé de démontage dans l'optique de réaliser une nouvelle structure de type SOI que l'on appellera ici deuxième SOI. Un tel procédé, à priori moins direct que les techniques évoquées ci-avant présente cependant quelques intérêts. L'exemple choisi ici concerne la réalisation d'une deuxième substrat SOI avec un oxyde enterré de 500Å, épaisseur qu'il est délicat d'obtenir avec un tel procédé mené en direct.

La première structure est obtenue selon l'une des voies décrites précédemment pour aboutir au substrat démontable correspondant à la figure 1. La couche 14 de silicium monocristallin pour cet exemple sera la future couche active. Sur ce substrat démontable dont la couche de liaison a été d'une part rugosifiée avant collage et qui n'a d'autre part pas subi de traitement thermique de renforcement à des températures très élevées (préférentiellement inférieures à 1100°C et encore mieux en deçà de 1000, voire 900°C), un oxyde 15 de 500Å est formé par oxydation thermique pour mener à la structure représentée en figure 2. Cet oxyde deviendra le futur oxyde enterré de la deuxième structure SOI. Ce substrat démontable (11+12+13+14+15) est, dans l'exemple considéré collé par adhésion moléculaire sur un substrat de silicium 16 (voir figure 3) qui deviendra le futur support final de la couche active. L'empilement obtenu est de préférence stabilisé à haute température (1100°C) pour consolider fortement le second collage à l'interface des couches (15) et (16). Le premier collage subissant le même traitement aura cependant une tenue mécanique inférieure au deuxième collage du fait de sa rugosification préalable. Pour le décollement, on peut utiliser une méthode mécanique et chimique. Ainsi, on commence par plonger l'empilement obtenu dans un bain de HF, dont un des buts est de surgraver l'oxyde (12) et 13 en partant des bords de l'ensemble. Les deux interfaces 12/13 et 15/16 vont être préférentiellement attaquées. De plus, l'interface 12/13 du substrat démontable est de façon avantageuse une interface oxyde/oxyde. Ainsi l'attaque est facilitée à l'interface 15/16 qui est entre de l'oxyde et du silicium. Donc, lors de cette première étape de décollement, on attaque moins de surface au niveau de l'interface du second collage qu'au niveau de l'interface du substrat démontable. Une séparation à caractère mécanique (jet d'eau sous pression comme dans le document EP 0925888, jet d'air comprimé comme dans le document FR 2796491, traction comme dans le document WO 00/26000, insertion d'une lame ... ) permet de libérer complètement la structure finale 13+14+15+16 (voir la figure 4). Suite à l'enlèvement de l'oxyde 13, par exemple par attaque HF, la structure finale SOI est enfin obtenue (figure 5). La plaque 11 de Si, qui a servi de substrat au sein du substrat démontable, peut être recyclée et réutilisée, par exemple pour la réalisation d'un autre substrat démontable (après, de préférence, élimination de la couche 12).

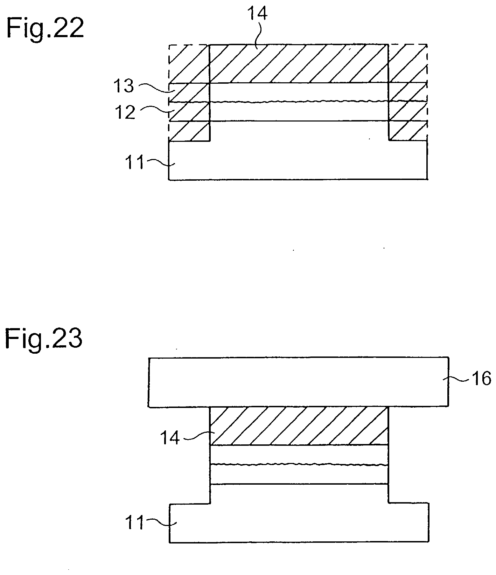

Pour faciliter l'initiation de la séparation, d'autres moyens peuvent consister à éliminer au moins partiellement une couronne extérieure du substrat. Pour ceci, les techniques de gravure chimiques, sèche ou humide, ou d'autres techniques mécaniques de polissage, de découpe laser etc.. peuvent être employées localement au niveau de la couronne (ce qui donne la configuration de la figure 22 où les zones hachurées sont à retirer, ce qui, après fixation d'un second substrat donne la configuration de la figure 23).

Il est à noter que l'oxyde enterré de 500Å 15 formé au préalable sur la couche 14 aurait pu être formé sur le substrat 16 avant collage et non sur la couche 14. Une autre variante eut consisté à diviser l'épaisseur de 500Å en deux parties pour former une partie sur le substrat 16, par exemple 250Å, et l'autre partie sur la couche 14, 250 Å dans l'exemple respectivement.

Il est à noter que si les deux interfaces collées par adhésion moléculaire sont toutes deux du type oxyde/oxyde, la stabilisation du deuxième collage à haute température peut avoir été conduite en sorte de garantir que l'attaque HF se fait préférentiellement au niveau de la première interface. Dans ce procédé la création d'une première interface à faible tenue mécanique a permis de séparer préférentiellement l'empilement complet selon la première interface de collage.

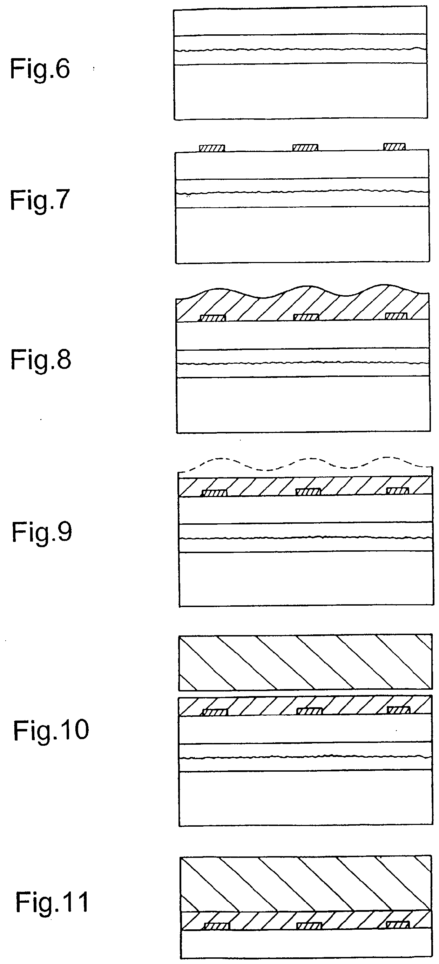

Un autre exemple de mise en oeuvre du procédé selon l'invention concerne la réalisation de structures de transistors dites à double grille (voir les figures 6 à 11). Les premières opérations liées à la fabrication des transistors consistent essentiellement à réaliser la première grille (figure 7) du transistor CMOS selon une technologie conventionnelle sur un substrat démontable (figure 6) tel que celui décrit en figure 1, identique en tout point au cas décrit ci-avant pour la réalisation de structures SOI à oxyde enterré fin. La température de stabilisation du collage peut éventuellement être réduite dans une gamme de température de l'ordre de 900/1000°C. Sur ce substrat est ensuite déposée (figure 8) une couche d'oxyde d'une épaisseur de l'ordre du µm par une technique conventionnelle de dépôt (CVD par exemple). Cet oxyde est planarisé (figure 9) selon une technique conventionnelle de polissage mécano-chimique. Ensuite, on procède (figure 10) à un collage par adhésion moléculaire avec un autre substrat de silicium 16. Ce collage est stabilisé préférentiellement à une température de 1000 à 1100°C si les structures formées pour la première grille le supportent, à des températures de l'ordre de 900/1000°c sinon. Enfin l'on procède à la séparation (figure 11) de manière identique au cas précédent (insertion de lame, jet d'eau sous pression ou d'air comprimé etc ..). Avant de reprendre le processus de fabrication du transistor, notamment pour la réalisation de la deuxième grille, le résidu de la couche d'oxyde 13 est enlevé par gravure chimique. Du fait de l'emploi d'une attaque de l'oxyde avec une solution d'acide HF dont on connaît la sélectivité d'attaque par rapport au silicium, la gravure s'arrête naturellement une fois que l'oxyde est entièrement gravé, permettant de retrouver une surface de silicium. Cette technique de démontage présente pour avantage majeur par rapport à d'autres techniques par exemple fondées sur la fracture, obtenue par exemple grâce à une implantation, de ne pas nécessiter de séquences de finition trop complexes et délicates quant à leur potentiel de création de défauts tels que le présente par exemple une opération de polissage final.

Le même processus peut-être utilisé pour de nombreuses autres applications. Si la première structure SOI correspondant à la figure 1 est utilisée pour réaliser des transistors, circuits, composants etc.., ceux-ci peuvent être reportés en final sur de nombreux types de support spécifiques. Par exemple, le substrat 16 peut être choisi pour ses propriétés isolantes d'un point de vue électrique (silicium haute résistivité, Quartz, saphir, ...) pour fournir un support idéal aux circuits hyperfréquences et de télécommunications, limitant ainsi les pertes dans le substrat. Pour des applications liées aux écrans plats, on choisira pour le support final un substrat transparent, par exemple en silice fondue.

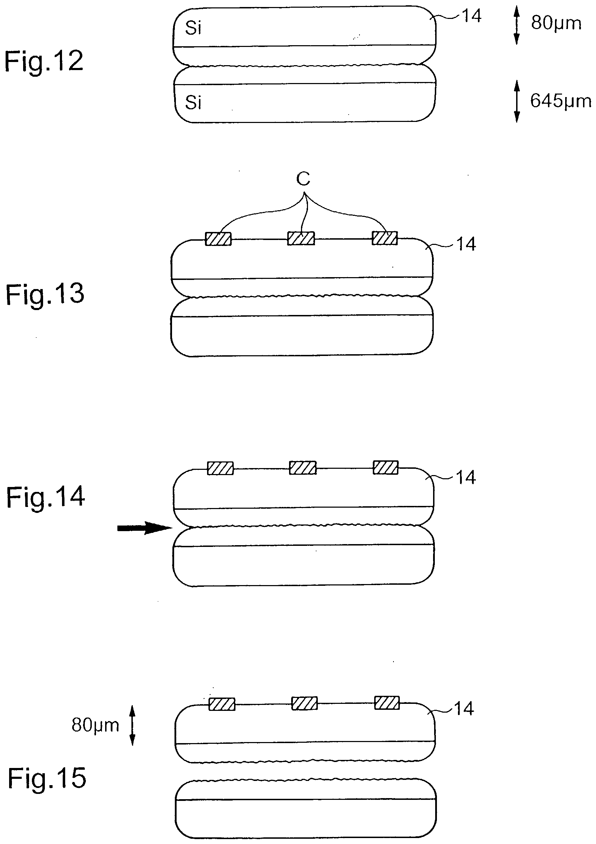

Un autre exemple du démontage, qui ne fait pas partie de l'invention, est brièvement décrit ici pour la réalisation de circuits sur substrats fins (figures 12 à 15). Les épaisseurs d'intérêt en final sont typiquement en dessous de quelques centaines de µms, voire de l'ordre de quelques dizaines de µms. Elles concernent par exemple les applications de puissance ou les applications de carte à puce et autres circuits pour lesquels on recherche une certaine souplesse (supports plastiques, supports courbes, etc ..). Dans cet exemple, nous nous intéressons à un type de démontage ne nécessitant pas de report sur un substrat cible. Le but ici est de séparer, sans report, la couche 14 après réalisation des circuits ou composants, dans le cas où cette couche 14 est suffisamment épaisse pour être autoportée mais trop fine pour subir sans dommage un procédé de réalisation collective de circuits (typiquement en dessous de quelques centaines de µms, voire de l'ordre de quelques dizaines de µms). Le procédé de réalisation du substrat démontable reste identique à l'un de ceux décrits précédemment pour mener à la structure de la figure 1 par exemple. Si l'on s'intéresse au silicium en diamètre 200mm, l'épaisseur standard de substrats est de 725µm. Si l'application requiert un substrat final de 80µm par exemple, on choisira (figure 12) pour le substrat support 11 un substrat de silicium d'épaisseur de 725 - 80 = 645 µm. L'ensemble après assemblage correspond donc aux épaisseurs standards et résiste de manière satisfaisante aux procédés de fabrication de composants. Après la réalisation de ces derniers (figure 13), l'une des techniques de démontage citées auparavant peut être utilisée (figure 14) à la différence que le substrat 16 peut être omis. Après démontage, la seule couche 14 autoportée (figure 15) représente le substrat final d'intérêt caractérisé par un substrat d'épaisseur de 80µm comprenant les composants.

Suivant les opérations technologiques qui doivent être réalisées sur le substrat démontable avant la séparation, notamment les traitements thermiques, chimique et selon la nature des contraintes mécaniques, les paramètres de préparation de l'interface de démontage devront être adaptées. Par exemple, si le substrat démontable consiste en une couche de surface en germanium possédant une interface de collage SiO2-SiO2 devant subir une température d'épitaxie de 550°C (cas typique dans le cas de la croissance de GaInAs constituant une cellule solaire pour le spatial), alors la rugosité devra être avantageusement de 0,4 nm rms pour que le substrat soit démontable.

Un autre exemple, qui ne fait pas partie de l'invention, concerne la réalisation de circuits pour cartes à puces pour lesquels la souplesse du support devient critique, d'une part du fait de l'augmentation de la taille des circuits, et d'autre part car la tendance est à vouloir des cartes de plus en plus résistantes aux déformations. Un support de silicium monocristallin dont l'épaisseur est supérieure à la cinquantaine de µms est dans ce cadre trop cassant du fait de sa trop grande épaisseur lorsrqu'il est soumis à une effort de flexion tel que peut en subir régulièrement une carte à puces.

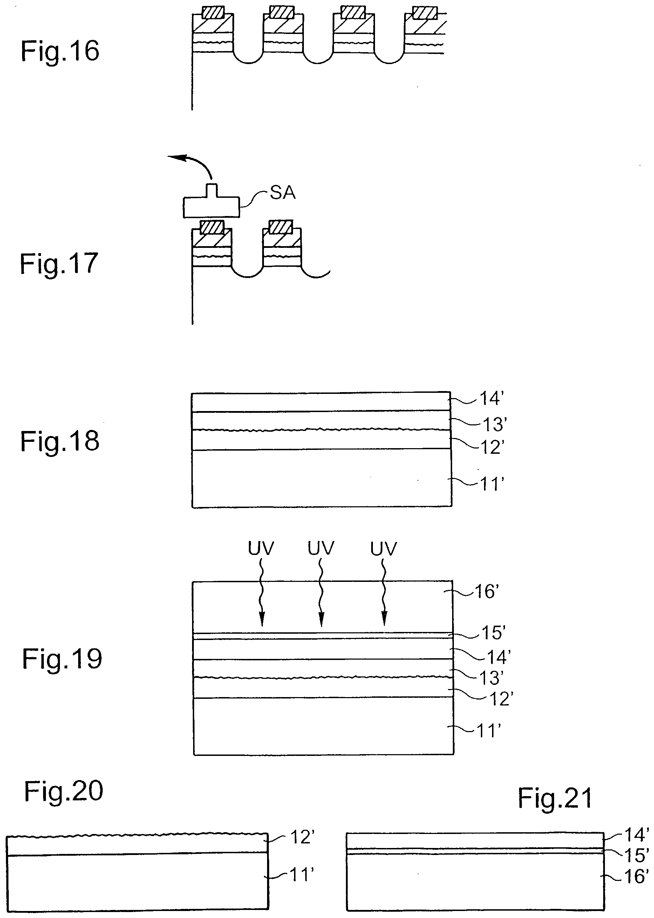

Il est à noter que, pour la réalisation des puces, on peut prévoir (voir figure 16), à partir de la configuration de la figure 13, des entailles isolant des parcelles qu'un outil d'arrachement (SA) permet d'enlever individuellement (figure 17).

Dans un exemple, qui ne fait pas partie de la invention, la figure 18 représente un ensemble de départ similaire à celui de la figure 1, avec un substrat de départ 11', recouvert d'une couche d'oxyde de silicium 12', elle-même collée par adhésion moléculaire à une seconde couche d'oxyde de silicium 13', elle-même recouverte d'une couche 14' en silicium. Les circuits sont réalisés au sein de la couche 14' de silicium. Puis, pour l'assemblage sur le deuxième support 16', on choisit de préférence une colle qui permet d'obtenir une couche 15 très fine, tout en ayant une tenue mécanique la plus forte possible à basse température, par exemple <400°C, pour ne pas risquer de détériorer les composants de la couche active réalisés avant cette étape de collage. Il peut avantageusement s'agir de colles thermodurcissables voire de colles durcissables par application de rayons UV (il suffit dans ce cas de choisir un substrat final 16' qui est transparent aux UV) - figure 19.

Dans ce exemple, qui ne fait pas partie de la invention, pour décoller le substrat démontable (ici selon l'interface de collage 12'/13'), il peut paraître délicat de réaliser un décollement purement chimique de type « lift-off » car les colles adhésives, ainsi que les substrats transparents aux UV (de quartz et de verre, en pratique) ne sont pas totalement inertes aux produits chimiques (HF, solvants,...). Par contre, pour décoller la structure au niveau de l'interface 12'/13', une action purement mécanique peut être suffisante si l'énergie de collage au niveau de l'interface démontable a été choisie de manière à être inférieure à la tenue de la colle adhésive et des différentes couches composant les circuits intégrés (cela peut être assez facilement obtenu). Il est alors possible de réutiliser le substrat 11' plusieurs fois.
Pour faciliter le démontage, il peut être avantageux d'éliminer une couronne extérieure du substrat. Outre une attaque chimique limitée de la couronne extérieure du substrat, il est possible d'autre part d'éliminer celle-ci en réalisant une découpe circulaire de la structure après le collage adhésif. Cette découpe peut être avantageusement réalisée par laser - voir les figures 22 et 23.

De façon générale, on obtient le résidu du premier substrat, support du substrat jusqu'ici dénommé "démontable" (figure 20) réutilisable après, de préférence, polissage de la couche 12' ainsi que la couche active 14' reportée sur un autre support 16' comme dans le cas de la figure 21, ou libre et autoportée si l'épaisseur de la couche 14' le permet.

A la différence des exemples précédents, le second substrat 16' peut en variante n'être qu'un substrat intermédiaire dans un procédé bien plus long. La structure obtenue en figure 21 peut être elle-même une structure démontable. La réalisation se poursuivra alors, ou par la suppression pure et simple de ce substrat intermédiaire 16' ou par un autre report de couche sur encore un autre support, en général avec suppression du substrat 16'. Le substrat démontable obtenu à l'aide de la technique décrite auparavant est collé par adhésif, après avoir été « processé », sur le substrat intermédiaire. Ce substrat intermédiaire peut être un substrat rigide ou souple (voir les exemples précédents). S'il est rigide ce peut même être une plaque de silicium.

Dans un exemple, qui ne fait pas partie de l'invention, pour le collage adhésif, on peut aussi envisager l'utilisation de films adhésifs connus de l'homme de l'art notamment pour procéder aux opérations de découpe de plaquettes de silicium et d'encapsulation de circuits intégrés ou encore de "packaging" ou encore de "back-end" selon deux expressions anglo-saxonne (« sticky bleu », films adhésif en Teflon®, ..). Si ce film est adhésif sur ses deux faces, il peut être judicieux de coller en face arrière de ce film, en tant que substrat intermédiaire, un substrat ou support permettant la rigidification de l'ensemble au moment de la découpe.

Dans un exemple, qui ne fait pas partie de l'invention, les techniques de décollement envisageables incluent l'application de forces de traction et/ou de cisaillement et/ou de flexion. A ces applications de forces, il peut être judicieux de coupler une attaque chimique de l'interface voire d'autres moyens tels que ultrasons. Dans le cas où l'interface à décoller est du type oxyde, l'attaque de l'interface à énergie faible est facilitée à l'interface de collage et donc le transfert de la couche processée sur le substrat intermédiaire est favorisé. Dans ces conditions, il est avantageux que les couches processées soient protégées (par exemple par un dépôt supplémentaire de nitrure dans le cas d'une attaque HF) .

Les moyens d'application des contraintes peuvent être mécaniques (par insertion d'une lame au niveau de l'interface de collage, notamment) et/ou par l'utilisation d'une pince de décollement (WO 00/26000) et/ou par jet, par l'insertion d'un flux gazeux comme cela est décrit dans le document FR 2796491 et/ou d'un liquide (EP 0925888, EP 0989593). Dans le cas du flux gazeux (ou même d'un liquide, avec par exemple du HF si l'interface est de l'oxyde), le substrat démontable peut avantageusement être préalablement préparé (par gravure chimique par exemple) pour pouvoir amener le fluide localement au niveau de l'interface de collage. Cette condition permet de faciliter le décollement préférentiellement au niveau de l'interface de collage des structures multicouches, où doit se faire le décollement, en protégeant les différentes couches de la structure comportant les composants. Ainsi, il est possible de décoller l'interface de collage même lorsque l'adhérence entre elles des couches internes des composants est faible.

Dans un exemple, qui ne fait pas partie de l'invention, le substrat intermédiaire, parfois appelé « poignée » peut ensuite être découpé (ou non), totalement ou en partie (entailles ou débuts de découpe) en éléments correspondant aux composants électroniques et qui peuvent être reportés sur différents supports. Ce report peut être un report collectif où l'ensemble des composants, même s'ils ne sont reliés entre que par un support, sont transférés en même temps lors de la même opération technologique ou être un report composant à composant (ou puce à puce) s'ils font l'objet les uns après les autres de ce report. Ces supports peuvent être en plastique comme sur une carte à puce et, dans ce cas on utilise avantageusement de la colle pour le report. Les éléments peuvent aussi être reportés sur une plaque comportant d'autres dispositifs électroniques ou optoélectroniques et, dans ce cas, le report peut mettre à nouveau en oeuvre une technique d'adhésion moléculaire (voir les figures 1 à 5 en imaginant la présence supplémentaire de composants réalisés dans la couche (14)). Les éléments peuvent être reportés par des moyens classiques tels ceux dénommés « pick and place ». Les éléments peuvent être également reportés sur un autre support pour améliorer les propriétés par exemple d'un point de vue thermique.

Ensuite, en exerçant une contrainte ou en chauffant localement (à l'aide d'un laser par exemple), la couche mince, préalablement collée sur son support définitif, peut être séparée (élément par élément, ou globalement) de sa poignée par l'intermédiaire de forces mécaniques.

Le procédé selon l'invention spécifie un décollement de la couche de son substrat au niveau global, c'est-à-dire à l'échelle de la totalité du substrat. Dans un exemple, qui ne fait pas partie de l'invention, on peut délimiter des parcelles, dont la forme est clairement liée aux puces ou composants qui seront réalisés à partir de la couche active. Une variante intéressante consiste à utiliser une des techniques classiques de découpe de composant (sciage, découpe laser, ..) pour venir découper ou délimiter des tranchées, au moins partiellement autour des puces, parcelles etc... Une autre variante intéressante repose sur l'utilisation de gravures chimiques associées à une opération de photo-lithographie, pour réaliser des tranchées identiques et/ou provoquer l'enlèvement de la zone de liaison au niveau du contour des puces.. A titre d'exemple, après avoir préparé le collage par adhésion moléculaire sur une grande étendue, on découpe (figure 16) les couches 13 et 14 suivant le contour représenté, puis on décolle chaque parcelle vis-à-vis du substrat, ce qui revient à considérer que l'on décolle le substrat vis-à-vis de chaque parcelle (en variante, on peut découper toutes les couches, soit l'ensemble des parcelles à la fois).

Les exemples de mise en oeuvre décrits précédemment ne se limitent bien entendu pas au simple cas du silicium monocristallin mais peuvent s'étendre à de nombreux matériaux tels que d'autres matériaux semi-conducteurs (Ge, SiGe, SiC, GaN et autres nitrures équivalents, AsGa,InP, ..) ou en matériaux ferroélectriques ou piézo-électriques (LiNbO3, LiTaO3) ou magnétiques, qu'ils fassent l'objet de réalisation de composants ou non avant le démontage.

Il a déjà été cité que pour le cas correspondant à un substrat démontable consistant en une couche de surface en germanium possédant une interface de collage SiO2-SiO2 devant subir une température d'épitaxie de 550°C (cas typique dans le cas de la croissance de GaInAs constituant une cellule solaire pour le spatial), alors la rugosité devra être de avantageusement de 0,4 nm rms pour que le substrat soit démontable.

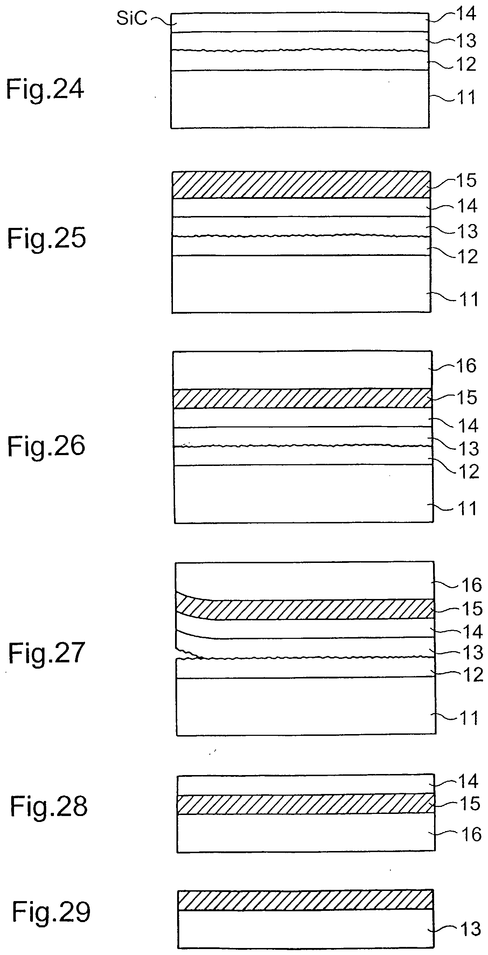

Un autre exemple (figures 24 à 29) est celui où l'on souhaite réaliser une étape d'épitaxie d'un empilement épitaxial sur un substrat démontable (figure 24). Ceci est notamment le cas pour la réalisation de LEDs bleues et blanches ou de diodes laser en couches fines (par exemple pour une meilleure extraction de la lumière émise ou pour une meilleure évacuation de la chaleur grâce à un report sur un substrat bon conducteur thermique tel que le cuivre ou diamant). Dans ce cas, l'empilement épitaxial considéré (figure 25) est à base de semi-conducteurs composés dérivés du GaN (AIN, GaAIN, GaAlInN, ..). Un procédé consiste à former selon une des méthodes décrites auparavant, une structure démontable équivalente à celle de la figure 1 (ou des figures analogues précitées) où la couche (14) est du SiC 6H (face Si reportée vers le haut selon les figures), les couches (12) et (13) sont des oxydes de Silicium et le substrat (11) est en SiC polycristallin (ou saphir). Sur cette structure on procède à la formation par épitaxie de l'empilement à base de nitrures. Cette épitaxie peut être réalisée par exemple par des techniques d'épitaxie bien connues de l'homme du métier sous les acronymes anglo-saxon de MBE (pour Molecular Beam Epitaxy) pour une catégorie d'entre elles ou par MOCVD (Metallo-Organic Chemical Vapor Déposition) pour une autre. Dans le premier cas, les températures de croissance épitaxiale dépassent rarement 600°C tandis que les températures typiques pour la seconde peuvent atteindre 1100°C. Pour chacune de ces deux techniques, le choix des paramètres liés à la tenue mécanique de l'interface de collage (rugosification, renforcements par traitements thermiques, hydrophilie, ..) doit être optimisé. Dans le second cas, on choisira par exemple un des procédés décrits précédemment basé sur une rugosification des deux couches d'oxyde (12) et (13) par attaque HF. Cette structure fait ensuite l'objet de la croissance épitaxiale MOCVD pour réaliser à 1100°c un empilement dont l'épaisseur est de l'ordre de 1µm. Optionnellement, la structure est recuite avant épitaxie, typiquement dans la gamme de 900 à 1200°C afin de consolider fortement la tenue mécanique de la couronne. Après croissance l'ensemble fait l'objet d'un dépôt d'oxyde, d'une planarisation par CMP, et d'un collage par adhésion moléculaire d'un substrat 16 (par exemple sur un substrat silicium) et d'un recuit à 1100°C pour renforcer ce dernier collage. Enfin, on procède au démontage du substrat démontable selon l'interface de collage (figure 27). A titre préliminaire, et en guise d'option avantageuse, quelques heures en bain de HF à 50% permettent de graver latéralement à partir des bords du substrat la couche d'oxyde sur quelques millimètres. Ensuite, une séparation par efforts mécaniques est réalisée, par exemple par insertion d'une lame, par application d'un jet d'eau sous pression ou d'air comprimé selon par exemple les techniques décrits précédemment, conduisant à ce qui est représenté à la figure 28. Une désoxydation finale permet enfin d'enlever le résidu la couche (13) d'oxyde. Optionellement (figure 29), au moins la couche 14 de SiC ayant servi de couche de nucléation à l'empilement épitaxial peut être supprimée par exemple par gravure. La réalisation de diodes peut voir lieu avant ou après le transfert final.

Il peut être noté que selon l'invention, une alternative à la rugosification ou à l'effet d'hydrophilie est d'utiliser des températures de recuit de l'interface de collage à basse température au lieu du traditionnel niveau d'environ 1100 à 1200 °C dans le cas de collages avec des surfaces non nécessairement rugosifiées. Les températures de recuit sont avantageusement optimisées pour obtenir une énergie de liaison suffisante pour les composants mais suffisamment faibles pour permettre un démontage le moment voulu.

Selon un aspect de l'invention, original en soi, il y a, après réalisation de l'interface, et une étape de réalisation technologique (réalisation de structures homogènes ou non, de composants en tout ou partie, d'une épitaxie,...) un décollement avec gravure chimique et application d'efforts mécaniques, par exemple par des jets (d'air ou autres fluides), localisés à l'interface de collage du substrat démontable.

Les inventeurs ont donc démontré qu'on pouvait tirer profit de la rugosification et de l'hydrophilie des surfaces pour mettre au point des interfaces de collage démontables, même après des recuits à haute température, jusqu'à 1100°C. En combinant de manière astucieuse la préparation de rugosification avant collage avec des traitements de recuits thermiques adaptés, il a été ainsi démontré que des substrats de type SOI démontables pouvaient supporter, sans séparation inopinée au niveau de l'interface d'assemblage, l'essentiel des étapes d'un procédé de réalisation de transistors CMOS (comprenant notamment des étapes de traitement thermique à haute température, typiquement 1100°C, ainsi que des étapes de dépôt de couches contraintes, par exemple de nitrure), et pouvaient à posteriori être démontés selon l'interface de collage par l'application volontaire de contraintes mécaniques contrôlées. Cette démonstration a aussi été réalisée pour d'autres applications, liées par exemple à la réalisation d'une étape de dépôt épitaxial avant le démontage du substrat.

## Revendications

1. Procédé de réalisation d'une structure démontable comportant :
- un premier collage par adhésion moléculaire d'une face d'une première plaque sur une face d'une deuxième plaque, au moins l'une de ces faces comportant une couche d'oxyde (12, 13) de silicium,
- avant le premier collage, une étape de traitement de l'une au moins de ces faces propre à mettre la tenue mécanique de l'interface du premier collage entre les deux plaques à un niveau contrôlé,
- ce premier collage est suivie d'une étape de démontage de la totalité de l'interface du premier collage,
- entre le premier collage de la structure et cette étape de démontage est effectuées une étape de réalisation de tout ou partie de composants microélectroniques, optoélectroniques, mécaniques, piézoélectriques, supraconducteurs ou magnétiques et un deuxième collage par adhésion moléculaire au cours duquel la structure est collée à un substrat (16, 16'), ledit niveau contrôlé de tenue mécanique étant donc compatible avec ladite étape de réalisation sur au moins l'une des deux plaques de tout ou partie de composants, et compatible également avec ladite étape de démontage ultérieur de la structure et inférieur à la tenue mécanique de l'interface du deuxième collage, et
- le démontage de la structure au niveau de l'interface du premier collage est réalisé :
• en plongeant l'empilement de la structure démontable et du substrat (16) collé sur cette structure démontable dans un bain d'acide HF pour attaquer moins de surface au niveau de l'interface du deuxième collage qu'au niveau de l'interface du premier collage, puis
• en mettant en oeuvre une séparation à caractère mécanique au niveau de l'interface du premier collage.

2. Procédé selon la revendication 1, **caractérisé en ce que** l'étape de traitement comprend une étape de modification de la rugosité d'au moins une des faces et l'étape de modification de la rugosité consiste en une étape d'augmentation de la rugosité.

3. Procédé selon la revendication 2, **caractérisé en ce que** l'étape d'augmentation de la rugosité d'une face comporte une attaque chimique localisée de cette face.

4. Procédé selon la revendication 3, **caractérisé en ce que** l'attaque chimique est une attaque acide.

5. Procédé selon la revendication 4, **caractérisé en ce que** l'attaque acide est effectuée avec de l'acide HF.

6. Procédé selon la revendication 5, **caractérisé en ce que** ladite face étant recouverte de la couche d'oxyde de silicium, l'attaque acide résulte en un enlèvement d'une épaisseur de la couche d'oxyde de silicium de moins de 1 µm.

7. Procédé selon l'une quelconque des revendications précédentes, dans lequel, avant le deuxième collage, le procédé comporte la formation d'une couche d'oxyde (15) au moins sur le substrat ou sur la structure démontable de sorte qu'au moins l'une des faces collées lors du deuxième collage comporte cette couche d'oxyde.

8. Procédé selon l'une quelconque des revendications à 7, **caractérisé en ce que**, après le deuxième collage mais avant le démontage, on applique un traitement thermique de stabilisation de l'interface du deuxième collage, l'interface du premier collage ayant une tenue mécanique inférieure à celle de cette deuxième interface du fait de sa rugosification préalable.

9. Procédé selon l'une quelconque des revendications 1 à 8, **caractérisé en ce que** on réalise dans au moins une des deux plaques une couche mince, l'étape de réalisation de tout ou partie de composants étant effectuée sur cette couche mince.

10. Procédé selon la revendication 9, **caractérisé en ce que** la couche mince est obtenue par un amincissement mécanique et/ou chimique d'une plaque.

11. Procédé selon la revendication 9, **caractérisé en ce que** la couche mince est obtenue par fracture au niveau d'une zone fragile enterrée d'une plaque.

12. Procédé selon la revendication 11, **caractérisé en ce que** la zone fragile enterrée est obtenue par implantation d'espèces gazeuses.

13. Procédé selon l'une quelconque des revendications 1 à 12, **caractérisé en ce qu'**une au moins des plaques est découpée en au moins un élément avant le démontage.

14. Procédé selon l'une quelconque des revendications 7 à 13, **caractérisé en ce que** la couche d'oxyde est une couche d'oxyde de silicium.

15. Procédé selon l'une quelconque des revendications 1 à 14, **caractérisé en ce que** les plaques collées lors du premier collage sont réalisées en matériau semi-conducteur ou en matériau ferroélectrique ou en matériau piézoélectrique ou en matériau magnétique.

16. Procédé selon l'une quelconque des revendications 1 à 15, **caractérisé en ce que**, après démontage de la structure, l'une au moins des plaques est réutilisée.

17. Procédé selon l'une quelconque des revendications 9 à 12, **caractérisé en ce que** la couche mince est en matériau semi-conducteur.

## Patentansprüche

1. Verfahren zur Herstellung einer demontierbaren Struktur, welches umfasst:
- eine erste Klebung, durch molekulare Adhäsion, einer Seite einer ersten Platte auf eine Seite einer zweiten Platte, wobei wenigstens eine dieser Seiten eine Siliziumoxidschicht (12, 13) aufweist,
- vor der ersten Klebung, einen Schritt einer Behandlung wenigstens einer dieser Seiten, die geeignet ist, die mechanische Festigkeit der Grenzfläche der ersten Klebung zwischen den zwei Platten auf ein kontrolliertes Niveau zu bringen,
- auf diese erste Klebung folgt ein Schritt der Demontage der gesamten Grenzfläche der ersten Klebung,
- zwischen der ersten Klebung der Struktur und diesem Schritt der Demontage werden ein Schritt der Herstellung aller oder eines Teils der mikroelektronischen, optoelektronischen, mechanischen, piezoelektrischen, supraleitenden oder magnetischen Komponenten und eine zweite Klebung durch molekulare Adhäsion, bei welchem die Struktur auf ein Substrat (16, 16') geklebt wird, durchgeführt, wobei das kontrollierte Niveau der mechanischen Festigkeit daher mit dem Schritt der Herstellung aller oder eines Teils der Komponenten auf wenigstens einer der zwei Platten vereinbar ist und auch mit dem Schritt der späteren Demontage der Struktur vereinbar ist und geringer als die mechanische Festigkeit der Grenzfläche der zweiten Klebung ist, und
- die Demontage der Struktur an der Grenzfläche der ersten Klebung wird durchgeführt:
• durch Eintauchen des Stapels der demontierbaren Struktur und des auf diese demontierbare Struktur geklebten Substrats (16) in ein HF-Säurebad, um weniger Fläche an der Grenzfläche der zweiten Klebung als an der Grenzfläche der ersten Klebung anzugreifen, anschließend
• durch Durchführen einer Trennung an der Grenzfläche der ersten Klebung auf mechanische Weise.

2. Verfahren nach Anspruch 1, **dadurch gekennzeichnet, dass** der Schritt der Behandlung einen Schritt der Änderung der Rauigkeit wenigstens einer der Seiten umfasst und der Schritt der Änderung der Rauigkeit aus einem Schritt der Erhöhung der Rauigkeit besteht.

3. Verfahren nach Anspruch 2, **dadurch gekennzeichnet, dass** der Schritt der Erhöhung der Rauigkeit einer Seite ein lokales Ätzen dieser Seite umfasst.

4. Verfahren nach Anspruch 3, **dadurch gekennzeichnet, dass** das Ätzen ein saures Ätzen ist.

5. Verfahren nach Anspruch 4, **dadurch gekennzeichnet, dass** das saure Ätzen mit HF-Säure durchgeführt wird.

6. Verfahren nach Anspruch 5, **dadurch gekennzeichnet, dass**, wenn die Seite mit der Siliziumoxidschicht bedeckt ist, das saure Ätzen ein Abtragen einer Dicke der Siliziumoxidschicht von wenigstens 1 µm zur Folge hat.

7. Verfahren nach einem der vorhergehenden Ansprüche, wobei das Verfahren vor der zweiten Klebung die Ausbildung einer Oxidschicht (15) wenigstens auf dem Substrat oder auf der demontierbaren Struktur umfasst, derart, dass wenigstens eine der bei der zweiten Klebung geklebten Seiten diese Oxidschicht aufweist.

8. Verfahren nach einem der Ansprüche 2 bis 7, **dadurch gekennzeichnet, dass** nach der zweiten Klebung, jedoch vor der Demontage eine Wärmebehandlung zur Stabilisierung der Grenzfläche der zweiten Klebung angewendet wird, wobei die Grenzfläche der ersten Klebung aufgrund ihrer vorangegangenen Aufrauhung eine mechanische Festigkeit aufweist, die geringer ist als diejenige dieser zweiten Grenzfläche.

9. Verfahren nach einem der Ansprüche 1 bis 8, **dadurch gekennzeichnet, dass** in wenigstens einer der zwei Platten eine dünne Schicht hergestellt wird, wobei der Schritt der Herstellung aller oder eines Teils der Komponenten auf dieser dünnen Schicht durchgeführt wird.

10. Verfahren nach Anspruch 9, **dadurch gekennzeichnet, dass** die dünne Schicht durch eine mechanische und/oder chemische Dünnung einer Platte erhalten wird.

11. Verfahren nach Anspruch 9, **dadurch gekennzeichnet, dass** die dünne Schicht durch Aufbrechen an einem vergrabenen zerbrechlichen Bereich einer Platte erhalten wird.

12. Verfahren nach Anspruch 11, **dadurch gekennzeichnet, dass** der vergrabene zerbrechliche Bereich durch Implantation gasförmiger Spezies erhalten wird.

13. Verfahren nach einem der Ansprüche 1 bis 12, **dadurch gekennzeichnet, dass** wenigstens eine der Platten vor der Demontage in wenigstens ein Element zerschnitten wird.

14. Verfahren nach einem der Ansprüche 7 bis 13, **dadurch gekennzeichnet, dass** die Oxidschicht eine Siliziumoxidschicht ist.

15. Verfahren nach einem der Ansprüche 1 bis 14, **dadurch gekennzeichnet, dass** die bei der ersten Klebung geklebten Platten aus Halbleitermaterial oder aus ferroelektrischem Material oder aus piezoelektrischem Material oder aus magnetischem Material hergestellt sind.

16. Verfahren nach einem der Ansprüche 1 bis 15, **dadurch gekennzeichnet, dass** nach der Demontage der Struktur wenigstens eine der Platten wiederverwendet wird.

17. Verfahren nach einem der Ansprüche 9 bis 12, **dadurch gekennzeichnet, dass** die dünne Schicht aus Halbleitermaterial besteht.

## Claims

1. Process for producing a demountable structure including:
- forming a first bond by molecular bonding one side of a first wafer to one side of a second wafer, at least one of the sides including a silicon-oxide layer (12, 13); and
- before the first bond is formed, a step of processing at least one of these sides, said processing step being suitable for bringing the mechanical strength of the interface of the first bond between the two wafers to a controlled level;
- the formation of this first bond is followed by a step of demounting the entirety of the interface of the first bond;
- between the formation of the first bond of the structure and this demounting step a step of completely or partially producing microelectronic, optoelectronic, mechanical, piezoelectric, superconductor or magnetic components is carried out and a second bond is formed by molecular bonding, the structure being bonded to a substrate (16, 16') during said bonding, said controlled level of mechanical strength therefore being compatible with said step of completely or partially producing components on at least one of the two wafers, and also compatible with said subsequent step of demounting the structure, and lower than the mechanical strength of the interface of the second bond; and
- the structure is demounted at the interface of the first bond:
• by submerging the stack of the demountable structure and of the substrate (16) bonded to this demountable structure in an HF-acid bath in order to attack less area at the interface of the second bond than at the interface of the first bond, then
• by implementing a separation of mechanical character at the interface of the first bond.

2. Process according to Claim 1, **characterized in that** the processing step comprises a step of modifying the roughness of at least one of the sides and this step of modifying the roughness consists in a step of increasing the roughness.

3. Process according to Claim 2, **characterized in that** the step of increasing the roughness of a side includes a localized chemical attack of this side.

4. Process according to Claim 3, **characterized in that** the chemical attack is an acid attack.

5. Process according to Claim 4, **characterized in that** the acid attack is carried out with HF acid.

6. Process according to Claim 5, **characterized in that**, said side being covered with the silicon-oxide layer, the acid attack results in a removal of a thickness of the silicon-oxide layer of less than 1 µm.

7. Process according to any one of the preceding claims, wherein, before the second bond is formed, the process includes forming an oxide layer (15) at least on the substrate or on the demountable structure so that at least one of the sides bonded in the formation of the second bond includes this oxide layer.

8. Process according to any one of Claims 2 to 7, **characterized in that**, after the second bond has been formed but before the demounting, a heat treatment is applied to stabilize the interface of the second bond, the interface of the first bond having a mechanical strength lower than that of this second interface because of its prior roughening.

9. Process according to any one of Claims 1 to 8, **characterized in that**, in at least one of the two wafers, a thin layer is produced, the step of completely or partially producing components being carried out on this thin layer.

10. Process according to Claim 9, **characterized in that** the thin layer is obtained via chemical and/or mechanical thinning of a wafer.

11. Process according to Claim 9, **characterized in that** the thin layer is obtained by fracturing a buried fragile zone of a wafer.

12. Process according to Claim 11, **characterized in that** the buried fragile zone is obtained by implanting gaseous species.

13. Process according to any one of Claims 1 to 12, **characterized in that** at least one of the wafers is diced into at least one element before the demounting.

14. Process according to any one of Claims 7 to 13, **characterized in that** the oxide layer is a silicon-oxide layer.

15. Process according to any one of Claims 1 to 14, **characterized in that** the wafers bonded during the formation of the first bond are made of semiconductor material or of ferroelectric material or of piezoelectric material or of magnetic material.

16. Process according to any one of Claims 1 to 15, **characterized in that**, after the structure has been demounted, at least one of the wafers is reused.

17. Process according to any one of Claims 9 to 12, **characterized in that** the thin layer is made of semiconductor material.
